(19) Europäisches Patentamt / European Patent Office / Office européen des brevets

(11) **EP 4 095 712 A1**

(12) **EUROPEAN PATENT APPLICATION**

(43) Date of publication:
**30.11.2022   Bulletin 2022/48**

(21) Application number: **22174574.8**

(22) Date of filing: **20.05.2022**

(51) International Patent Classification (IPC):
**G06F 16/2455** $^{(2019.01)}$      **H03M 7/30** $^{(2006.01)}$

(52) Cooperative Patent Classification (CPC):
**G06F 16/24553; H03M 7/30**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority:  **28.05.2021   IT 202100014069**

(71) Applicant: **Università di Pisa**
**56124 Pisa (IT)**

(72) Inventors:
• **Vinciguerra, Giorgio**
**56127 PISA (IT)**
• **Manzini, Giovanni**
**56127 PISA (IT)**
• **Ferragina, Paolo**
**56123 PISA (IT)**

(74) Representative: **Lunati & Mazzoni S.r.L.**
**Via Carlo Pisacane, 36**
**20129 Milano (IT)**

(54) **COMPRESSION AND SEARCH PROCESS ON A GROUP OF DATA BASED ON MULTIPLE STRATEGIES**

(57)    It is provided a compression and search process (1) on a group of data based on multiple strategies, comprising: extracting a set of raw data from a source, selecting the raw data by eliminating any errors and obtaining usable data, manipulating the usable data to obtain compressed data, recording the compressed data on storage media, the manipulation is achieved by combining algorithms configured to organise the usable data into compressed data structures of the LA vector and block-tree type in such a way as to obtain compressed data that can be quickly interrogated.

**Description**

The present invention relates to a compression and search process on a group of data based on multiple strategies of the type specified in the preamble to the first claim.

In computer science, a data structure is an entity used to organise a set of data within the computer's memory, and possibly to store it in a mass memory. The data structure is a method of organising data and is therefore independent of what is actually contained in it. The choice of the data structures to be used is closely linked to that of the algorithms, which is why they are often considered together. Indeed, the choice of data structure inevitably affects the computational efficiency of the algorithms that manipulate it.

The data structures differ mainly according to the operations that can be performed on them and the performance offered.

The advent of big data and real-time applications has posed new challenges to developers tasked with designing systems to support efficient access to the huge amounts of data increasingly present in sectors such as fintech, biotech, IoT and digital media, to name but a few.

Consequently, the last fifteen years have seen a massive development of non-relational databases, known as NoSQL, in addition to traditional relational databases. In fact, non-relational databases have been developed with the intention of replacing traditional ones in cases where the latter are a constraint, thus achieving better performance in both time and space. A noteworthy implementation of the NoSQL system was carried out by Google starting in 2004 with Bigtable. In detail, Bigtable is a high-performance compressed NoSQL system at the core of many services such as Gmail, Google Maps, and YouTube.

Following the success of Bigtable, other major companies have developed efficient data management systems optimised for scalability, multicore processing and use in the cloud. Among the latter, two popular open-source products are Redis and RocksDB, the latter developed and maintained by Facebook. Basically, these systems are called 'key-value stores', or rather they are based on a dictionary structure: each stored value (value) is matched with a unique key (key) that allows it to be retrieved. An analysis of the open-source code of the most popular solutions shows that they perform operations using dated techniques, such as binary search and the "skip lists" (W. Pugh, Comm. ACM, 1990), thus ignoring some recent developments in data compression and the design of advanced data structures. In particular, such recent developments have shown how the operations of counting and selecting elements of a set can be effectively supported using two powerful primitives called 'rank' and 'select' respectively (G. Jacobson, Proc. IEEE FOCS, 1989). These primitives form the basis of more complex operations such as, for example, filtering data in a database using logical predicates, join operations between two or more tables, as well as operations of the type: search by key, by predecessor, or by range. In addition to time efficiency, modern SQL and NoSQL databases also aim at space efficiency as they are often deployed on shared servers in the cloud.

The known technique described includes some major drawbacks.

In particular, the most widespread systems use outdated data storage and interrogation techniques that often do not guarantee adequate performance in terms of space and time.

Moreover, such systems are not able to efficiently exploit the different types of regularities that real data can present.

In this situation, the technical task at the heart of the present invention is to devise a compression and search process on a dataset based on multiple strategies to substantially obviate at least some of the aforementioned drawbacks.

Within this technical task, it is an important aim of the invention to obtain a compression and search process on a group of data based on multiple strategies that efficiently and effectively finds and exploits the repetitiveness of the data to be indexed.

Another important aim of the invention is to realise a compression and search process on a dataset based on multiple strategies that provides efficient performance in terms of both space occupancy and time required to interrogate the data.

The technical task and purposes specified are achieved by a compression and search process on a group of data based on multiple strategies as claimed in the annexed claim 1.

Preferred technical solutions are highlighted in the dependent claims.

In the present document, the measurements, values, shapes and geometric references (such as perpendicularity and parallelism), when associated with words like "about" or other similar terms such as "approximately" or "substantially", are to be considered as except for measurement errors or inaccuracies due to production and/or manufacturing errors, and, above all, except for a slight divergence from the value, measurements, shape, or geometric reference with which it is associated. For instance, these terms, if associated with a value, preferably indicate a divergence of not more than 10% of the value.

Moreover, when used, terms such as "first", "second", "higher", "lower", "main" and "secondary" do not necessarily identify an order, a priority of relationship or a relative position, but can simply be used to clearly distinguish between their different components.

Unless otherwise specified, as results in the following discussions, terms such as "treatment", "computing", "determination", "calculation", or similar, refer to the action and/or processes of a computer or similar electronic calculation device that manipulates and/or transforms data represented as physical, such as electronic quantities of registers of a computer system and/or memories in, other data similarly represented as physical quantities within computer systems, registers or other storage, transmission or information displaying devices.

The measurements and data reported in this text are to be considered, unless otherwise indicated, as performed in the International Standard Atmosphere ICAO (ISO 2533:1975).

The compression and search process on a group of data based on multiple strategies according to the invention is globally referred to as number 1.

It is configured to be implemented and thus acted upon by a computer.

The process 1 makes it possible to convert a set of data from one format to another, or rather to convert raw data into information. In detail, process 1 comprises a sequence of steps.

The first phase consists of extracting a set of raw data from a source, which may be a data lake, data warehouse or other. The raw data extracted from the source undergoes a selection phase configured to eliminate errors such as redundant data, incomplete or incorrect data and thus obtain usable data. In the next step, the usable data is manipulated to obtain compressed data. The compressed data are then recorded on storage media. Specifically, the storage media may include mass storage or cloud storage media.

In particular, such manipulation is achieved by combining algorithms configured to organise usable data into compressed data structures of the LA vector type (presented in detail in the article by Boffa, Ferragina, Vinciguerra: "A learned approach to quicken and compress rank/select dictionaries", in Proceedings of the SIAM Symposium on Algorithm Engineering and Experiments, ALENEX, 2021) and block-tree (presented in detail in the article by Belazzougui, Cáceres, Gagie et al: "Block trees", Journal of Computer and System Sciences, 2020) in such a way as to obtain an effectively compressed and efficiently usable data set. Together, these algorithms define a new combined data structure. The resulting data structure is suitable for supporting counting and selection operations as described in more detail below.

The data can be represented by an ordered and compressed dictionary $A$ of $n$ distinct elements drawn from the universe of integers $[u] = \{0 ..., u\}$. Such an ordered dictionary $A$ supports the operation *rank(x)* operation, which returns the number of elements in $A$ that are less than or equal to x e *select(i)* which returns the *i*-th smallest element in $A$.

Since A is an ordered array A[1,$n$]element, the $A[i]$ element can be obtained by *select(i)*. Each element $A[i]$ is initially mapped to a point (i,A[i]) belonging to the Cartesian plane, for $i = 1,2, ..., n$. Intuitively, one can consider any function $f$ that passes through all such points as an encoding of A since it is possible to obtain $A[i]$ by querying $f$ (i).

The function $f$ can be implemented via a linear trait model as described by Boffa, Ferragina and Vinciguerra in the above-mentioned paper. Alternatively, the function $f$ can be implemented via a non-linear model.

The model error, linear or non-linear, is measured as the vertical distance between the value estimated by the model and the actual value of $A$ and is related to an integer parameter $\varepsilon$. Often the distribution of the data does not allow it to be represented by a single linear model, but it is sufficiently 'regular' that, for reasons of space and time, a solution combining a sequence of linear models (also called 'segments' in the following) is preferred, thus giving rise to what is known as a 'linear segment model'. In this case, a $\varepsilon$ linear stroke approximation for the array $A[1, n]$ is a partition of the set $\{1,...,n\}$ such that each element $A[k]$ of a partition $A[i,j]$ is covered by a segment of the linear stroke model represented by a pair of reals $<\alpha, \beta>$ such that $|(\alpha \cdot k + \beta) - A[k]| \leq \varepsilon$ for each value $k$ between $i$ e $j$, including extremes.

Of all the possible approximations $\varepsilon$ linear approximations, it is preferable to use the most succinct one, or rather the one with the smallest number of segments. This is a computational geometry problem that admits an algorithm of complexity in time $0(n)$ to the worst case. The structure introduced by Boffa, Ferragina and Vinciguerra in the previously cited paper and called LA vector, uses this succinct approximation $\varepsilon$ linear approximation to represent A and repairs the loss of information by storing the vertical errors in an array C of integers of $\lceil \log(2 \varepsilon + 1) \rceil$ bits each, called corrections (in the following, the logarithmic function is taken in base 2).

To respond to the operation *select(i),* LA vector uses a *rank* structure that requires constant time on a bit-vector of size $n$ to find the segment $<\alpha, \beta>$ that covers $i$ and returns the value $[(\alpha \cdot i + \beta)] + C[i]$.

To answer the operation instead *rank(x)* operation, a kind of binary search is carried out that exploits the information encoded in the linear $\varepsilon$ approximation at intervals.

In practical implementations, c $\geq$ 2 bits for each correction and is chosen $\varepsilon = 2^{c-1} - 1$. The bit occupation of an LA vector thus consists of a term $0(nc)$ representing the array of corrections C and a term $O(wm)$term, where w is the size of the memory word. The value m can be considered as a measure of compressibility of $A$ which takes into account the linearity of the points (i,A[i]). Although the input consists of an array $A$ of strictly increasing values, there may be significant repetition in the differences between consecutive elements of $A$. Approximations $\varepsilon$ linear approximations do not have the ability to find and exploit these types of repetitiveness.

Consider then a string $S[1,n]$ defined as $S[i] = A[i] - A[i - 1]$with A[0] = 0, and suppose that the sub-string $S[i,j]$ was previously encountered at $S[i', i' + j - i]$. Therefore, it is possible to write $S[i,j] = S[i',i' + j - i]$. Instead of finding a new set of segments that approximate the sub-array $A[i,j]$ as described above, it is possible to use, for that part of the array, the segments that approximate the sub-array $A[i', j']$ properly shifted to the right. Even if $A[i',j']$ is covered by many segments, the same shift will transform these segments into an approximation for $A[i,j]$, thus requiring significantly less space than is necessary with the explicit representation of the many segments, as is the case with the LA vector.

The new data structure solves the above-mentioned limitations of the LA vector by orchestrating the maximum error approximation models $\varepsilon$ with the block tree data structure and is therefore called the block-$\varepsilon$ tree. It is therefore a variant of the block tree built on a combination of the string $S$ and maximum error approximation models $\varepsilon$. In the following description, as maximum error approximation models $\varepsilon$ reference is made to the simplest case of a sequence of segments (or rather the aforementioned approximation $\varepsilon$ linear segment approximation), but the discussion is easily extended to other types of models. Initially, a block tree structure is constructed on the string $S$ (as specified in the work of Belazzougui, Cáceres, Gagie et al. mentioned above), in which each node implicitly represents the corresponding sub-array of $A$. The tree is thus 'pruned' so as to eliminate subtrees whose corresponding sub-array of $A$ can be covered more succinctly by segments and corrections, or rather whose representation with LA vector is more succinct than the representation with block tree.

Compared to an LA vector constructed on $A$, the block-$\varepsilon$ tree does not encode the segments and corrections corresponding to substrings of $S$ that have already been previously encountered. It therefore exploits the repetitiveness of $S$ to compress the approximation $\varepsilon$ linear stroke approximation at the base of an LA vector.

In contrast to the classical block tree, the block-$\varepsilon$ tree eliminates subtrees whose substrings can be encoded more efficiently by segments and corrections, or rather the approximate linearity of the sub-arrays of $A$.

The following describes in more detail the structure of a block-$\varepsilon$ tree, and how to orchestrate this interaction in query resolution *select* e *rank.*

It is assumed that $n = \delta 2^h$ for some integer $h$, where $\delta$ is the complexity of the string $S$ (see Navarro: "Indexing Highly Repetitive String Collections, Part I: Repetitiveness Measures", ACM Computing Surveys, 2021).

The block-$\varepsilon$ tree structure is organised in $h' \leq h$ levels. The first level, called level zero, logically divides the string $S$ into $\delta$ blocks of size $s_0 = n/\delta$. The blocks at level $l$ level have size $s_l = n/(\delta 2^l)$ because they are obtained by halving the level zero blocks until they reach the last level

$$h = \log\left(\frac{n}{\delta}\right)$$

where the blocks have dimension $s_h = 1$. At any level, if two consecutive blocks $S_q$ e $S_{q+1}$ form the leftmost occurrence in $S$ of their contents, then both $S_q$ and $S_{q+1}$ are marked. A marked block $S_q$ marked block that is not in the last level becomes an internal node of the tree. Such an internal node has two children corresponding to the two sub-blocks of equal size into which it is divided $S_q$. On the other hand, an $S_r$ on the other hand becomes a leaf of the tree because, by construction, its contents also appear at an earlier point of $S$ and it is therefore possible to encode it succinctly by storing a pointer q to the marked blocks $S_q$, $S_{q+1}$ at the same level $l$ containing its leftmost occurrence, at the cost of $\log\left(\frac{n}{s_l}\right)$ bits, and storing the offset $o$ of $S_r$ with respect to the beginning of the block $S_q$ at a cost of $\log s_l$ bits. Thus, the cost in space of this 'double' pointer is $\log n$ bits. Furthermore, to retrieve the values of A corresponding to $S_r$, the difference $\Delta$ between the value of $A$ corresponding to the beginning of $S_r$ and the value of $A$ at the previous occurrence of $S_r$, at the cost of $\log u$ bit. Overall, each unmarked block requires $\log n + \log u$ bits of space.

To describe the 'pruning' process mentioned above, a cost function is defined c on the nodes of the block-$\varepsilon$ tree. For an unmarked block $S_r$ the cost is defined $c(S_r) = \log n + \log u$ which takes into account the bit space occupied by $q$, $o$, e $\Delta$. For a block $S_q$ at the last level $h$, the cost is defined $c(S_q) = \log u$ which takes into account the bit space occupied by its only corresponding element of $A$. In the last case, either $S_q$ a block marked at level $l < h$, and therefore $S_q$ is an internal node of the tree. Assume that the elements of $A$ represented by this block may be approximated by a segment with error $\varepsilon_q \leq \varepsilon$.

It is also supposed that $\varepsilon_q$ is minimal, or rather that there is no $\varepsilon' < \varepsilon_q$ such that there exists a segment that approximates with error $\varepsilon'$ those same elements of $A$. Let $\kappa$ the space in bits occupied by the parameters $<\alpha,\beta>$ of the segment, e.g. $\kappa = 2 \log u + \log n$ if $\beta$ is encoded in $\log u$ bits and $\alpha$ is encoded as a rational number with a numerator having $\log u$ bits and a denominator having $\log n$ bits. In truth, other encodings, even entropic encodings of the parameters would be possible by inducing other trade-offs in time and space.

The block $S_q$ previously mentioned is therefore assigned a cost $c(S_q)$ defined recursively as:

$$c(S_q) = min \begin{cases} \kappa + s_l \log \varepsilon_q + \log \log u \\ 2 \log n + \sum_{S_x \in child\,(S_q)} c(S_x) \end{cases}$$

The first branch of the equation represents an encoding of the sub-array of $A$ corresponding to $S_q$ through a segment with approximation error $\varepsilon_q$ corrections of log $\varepsilon_q$ bits for each of the $s_l$ elements in $S_q$, and the exponent $y$ of $\varepsilon_q$ = $2^y$ - 1 to keep track of its value, respectively.

The second branch of the equation represents an encoding that recursively divides $S_q$ into two children. Finally, if there is no linear error approximation $\varepsilon$ (and therefore no approximation $\varepsilon_q$ with $\varepsilon_q \leq \varepsilon$) for $S_q$, one assigns to that $S_q$ the cost indicated in the second branch of the equation.

A post-order visit to the tree defined by the block-ε tree is sufficient to assign a cost to its nodes and possibly prune some of its subtrees. In particular, when returning from recursion on the two children of a block marked $S_q$ level $l$level, we check whether the first branch of the equation provides the minimum. If so, we prune the subtree rooted in $S_q$ and store the block encoding in its place via the parameters $<\alpha, \beta>$ and the $s_l$ corrections in an array $C_q$. Following this pruning, it is necessary to correct the destination of pointers that from an untagged block $S_r$ point to a descendant (pruned) of $S_q$. To do this, we first make sure that $S_r$ points to $S_q$. Furthermore, since any pointer always points to a marked pair of blocks, either both or only one of these two blocks belong to the pruned subtree. In the latter case, an additional pointer is required from $S_r$ to the block that does not belong to the pruned subtree. Overall, this produces a pruned tree with $h' \leq h$ levels.

As mentioned above, the block-ε tree can support various types of queries, and in particular supports the operations *select* e *rank*.

For the operation *select(i)*, one follows the path starting from the zero-level block where the position $i$ falls and proceeds to a leaf block. There are the following cases for a block visited at level $l$:

- The current block is an unmarked block $S_r$ pointing to $S_q$ with an offset $o$ and a difference value $\Delta = A[b]$ - A[a]value, where $b$ is the position corresponding to the beginning of $S_r$ and $a$ is the position corresponding to the beginning of the copy in $S_q$. First, we jump to $S_q$ o $S_{q+1}$ depending on whether $o < s_l$. Then, we transform the operation *select(i)* $\equiv A[i]$ into $\Delta + select(a + i - b) \equiv \Delta + A[a + i - b]$.
- The current block is a marked internal block. It is passed to the first or second child depending on whether $i$ mod $s_l$ < $s_l/2$ and continue calculating *select(i)*.
- The current block is a leaf block $S_q$ that stores the parameters $<\alpha, \beta>$ and local corrections $C_q$. It is returned $\alpha i + \beta$ + $C_q$ [$i$ mod $s_l$].
- The current block is a leaf block $S_q$ at the last level $h$then the corresponding single element is returned.

The time complexity of such a crossing is analysed below. First, if a pruned block is encountered, the traversal ends. If an untagged block is encountered, its pointer to a previous block is followed, which may correspond to a pruned subtree or an internal node. In the latter case, the traversal proceeds to one of the children with a constant time cost for the level. Therefore, the time complexity of *select(i)* e $O(h')$. For the operations of *rank*operations, a (possibly compressed) data structure is created that performs predecessor searches on the $\delta$ integers of A corresponding to the first elements of the zero-level blocks, or rather the integers $A[in/\delta]$ for $i$ = 1, ..., $\delta$. For example, one can use the structure presented by Belazzougui and Navarro in "Optimal lower and upper bounds for representing sequences", ACM

Transactions on Algorithms 2015, which performs searches in time $O(\log \log_w \frac{u}{\delta})$, where w is the size of the memory word. Furthermore, in each marked block $S_q$ in any level $l$ excluding the first and last, the value of $A$ corresponding to the central value of $S_q$ in order to descend in constant time to the correct child block.

The operation *rank(x)* then begins with a predecessor search in the above structure, which indicates the zero-level block into which it falls $x$and then proceeds to a leaf block. The traversal proceeds in a similar manner to the operation *select* described above. If the visited block is a leaf block $S_q$ level $l$level, its parameters are retrieved $<\alpha, \beta>$ and the correction array $C_q$ and then a binary search of x on the corrections $s_l$. Using Algorithm 1 of the above-mentioned article by Boffa, Ferragina and Vinciguerra, this search has a cost in time of $O(\log \varepsilon_q)$ and returns the result of *rank(x)*, which is the position in $A$ of the (predecessor of the) value x.

If the visited block is a marked internal block, it is descended to its left or right child in a constant time using the central value of the block mentioned above and the result of *rank(x)* in that block.

Finally, if the visited block is an unmarked block $S_r$, an operation is recursively invoked *rank* operation is recursively invoked on the marked block $S_q$ pointed to by $S_r$ with argument x - $\Delta$argument, where $\Delta$ is defined as above, and then is returned $b - a + rank(x - \Delta)$. The offset $b - a$ takes into account the jump to the left due to resolving the *rank* not on $S_r$ but on $S_q$.

Overall, the time complexity of the operation *rank* is given by the sum of the costs of the initial predecessor search, the crossing of the block-ε tree and the final binary search, for a total time complexity of

$$O(\log\log_w \frac{u}{\delta} + h' + \log \varepsilon)$$

.

Examples of possible variations to the proposed data structure include: the use in the block-ε tree of a branch factor greater than two; the use of a number of starting blocks other than $\delta$; the use of blocks of variable length (at any level of the structure); the use of non-linear models that also guarantee a maximum error ε; the use of other compressed indices or compressors instead of LA vectors; the use of techniques that allow the topology of the tree and also the various links between the nodes provided by the proposed solution to be stored in a succinct manner; the use of alternative definitions of the cost function c that promote one or more computational resources or parameters other than just the space occupied (e.g. efficiency of operations, energy consumption, amount of data transferred between memory layers, etc.); the use of more sophisticated pruning algorithms that take into account multi-criteria; support for dynamic operations of insertion, modification and deletion of elements from the set through the use of buffers or logs, or even dynamization techniques based on e.g. the division and union of nodes typical of block structures (B-tree).

The process 1 according to the invention achieves important advantages.

In fact, process 1 is able to exploit both the repetitiveness and approximate linearity of the data to be indexed to achieve better space compression without sacrificing the time efficiency of the supported query operations.

The invention is susceptible to variations within the inventive concept as defined by the claims.

Here, all details can be replaced by equivalent elements and the materials, shapes and sizes can be any.

**Claims**

1. Compression and search process (1) on a group of data based on multiple strategies including:

   - extracting a set of raw data from a source,
   - selecting these raw data, eliminating any errors and obtaining usable data,
   - manipulating said usable data to obtain compressed data,
   - recording such compressed data on storage media,

   and **characterised by the fact** that:
   said manipulation is realised by combining algorithms configured to organise these usable data into compressed data structures, of the LA vector and block-tree type, in such a way as to obtain compressed data that can be quickly interrogated.

2. Process (1) according to claim 1, wherein said usable data set is an ordered and compressed dictionary $A$ of $n$ distinct elements drawn from the universe of integers $[.u] = \{0..., u\}$. Said dictionary $A$ supports the operation *rank(x)* operation, which returns the number of elements in $A$ which are less than or equal to $x$ e *select(i)* which returns the $i$-th smallest element in $A$.

3. Process (1) according to any one of the preceding claims, wherein said ordered dictionary $A$ is encoded in a compressed manner by a function $f$ implemented by a linear trait model having an error, measured as the vertical distance between the prediction of said model and the actual value of $A$, limited above by an integer parameter $\varepsilon$.

4. Process (1) according to any one of the preceding claims, wherein said approximation by means of a linear stroke model is the most succinct of the possible approximations for said ordered dictionary $A$.

5. Process (1) according to any one of the preceding claims, wherein said ordered dictionary $A$ and a string $S[1, n]$ defined as $S[i] = A[i] - A[i - 1]$, with $A[0] = 0$, are used to construct a tree-like data structure which supports the compression of repeated substrings of $S$.

6. Process (1) according to any one of the preceding claims, wherein said tree-like data structure is further pruned and compressed by exploiting said linear stroke approximations.

7. Process (1) according to any one of the preceding claims, wherein said pruned and compressed tree data structure is interrogated to support counting (*rank*) and selection (*select*) of elements of *A*.

8. Data processing system comprising means for implementing a process (1) according to any one of the preceding claims.

9. Computer program comprising instructions which, when executed by said computer, enable said computer to perform a process (1) according to any one of claims 1-7.

10. Computer-readable storage media comprising instructions which, when executed by said computer, enable said computer to perform a process (1) according to any one of claims 1-7.

Europäisches
Patentamt

European
Patent Office

Office européen
des brevets

# EUROPEAN SEARCH REPORT

Application Number

EP 22 17 4574

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | Boffa Antonio ET AL.: "A "learned" approach to quicken and compress rank/select dictionaries", Society for Industrial and Applied Mathematics 2021 Proceedings of the Workshop on Algorithm Engineering and Experiments (ALENEX), 11 January 2021 (2021-01-11), pages 46-59, XP055883961, DOI: 10.1137/1.9781611976472.4 ISBN: 978-1-61197-647-2 Retrieved from the Internet: URL:http://pages.di.unipi.it/vinciguerra/publication/learned-rank-select/learned-rank-select.pdf [retrieved on 2022-07-25] * the whole document * | 1-10 | INV. G06F16/2455 H03M7/30 |
| X | BELAZZOUGUI DJAMAL ET AL: "Block trees", JOURNAL OF COMPUTER AND SYSTEM SCIENCES, ACADEMIC PRESS, INC., LONDON, GB, vol. 117, 18 November 2020 (2020-11-18), pages 1-22, XP086436874, ISSN: 0022-0000, DOI: 10.1016/J.JCSS.2020.11.002 [retrieved on 2020-11-18] | 1,8-10 | |
| A | * page 1, paragraph 1 - page 2; figure 1 * * page 3, paragraph 3 * * page 4, paragraph 5 - page 6 * * page 8, paragraph 7 - page 11, paragraph 8 * | 2-7 | |

| TECHNICAL FIELDS SEARCHED (IPC) |
|---|
| G06F H03M |

The present search report has been drawn up for all claims

| Place of search | Date of completion of the search | Examiner |
|---|---|---|
| The Hague | 26 July 2022 | Chinzer, Azzurra |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- A learned approach to quicken and compress rank/select dictionaries. **BOFFA ; FERRAGINA ; VINCIGUERRA.** Proceedings of the SIAM Symposium on Algorithm Engineering and Experiments. ALENEX, 2021
- **BELAZZOUGUI ; CÁCERES ; GAGIE et al.** Block trees. *Journal of Computer and System Sciences,* 2020

- **NAVARRO.** Indexing Highly Repetitive String Collections, Part I: Repetitiveness Measures. *ACM Computing Surveys,* 2021
- **BELAZZOUGUI ; NAVARRO.** Optimal lower and upper bounds for representing sequences. *ACM TRANSACTIONS ON ALGORITHMS,* 2015